# EUROPEAN PATENT APPLICATION

(11) **EP 4 651 696 A1**
(43) Date of publication of application: **19.11.2025**
(21) Application number: 24176246.7
(22) Date of filing: 16.05.2024
(51) Int. Cl.: H10N 60/01, H10N 69/00

(54) **A METHOD FOR PRODUCING A JOSEPHSON JUNCTION DEVICE**

(71) Applicant: Imec VZW, 3001 Leuven (BE)
(72) Inventor: Pokhrel, Ankit, 3001 Leuven (BE); Herr, Anna, 3001 Leuven (BE); Herr, Quentin, 3001 Leuven (BE); Renaud, Vincent, 3001 Leuven (BE); Tokei, Zsolt, 3000 Leuven (BE); Gupta, Anshul, 3001 Leuven (BE)
(74) Representative: Patent Department IMEC

(57) **Abstract**

A method for producing a Josephson junction device comprising a bottom superconducting electrode (27), a top superconducting electrode (18) and a barrier layer (17) sandwiched between said bottom and top electrodes, the method comprising the steps of producing on a planar support surface, a stack comprising a bottom superconducting layer, a barrier layer directly on said bottom superconducting layer, a top superconducting layer directly on the barrier layer; patterning the barrier layer and the top superconducting layer, so as to form a localized stack comprising the barrier (17) and the top electrode (18) of the device; patterning the bottom superconducting layer so as to form on the planar surface of the support substrate (2) the bottom electrode (27) of the device and the localized stack directly on the bottom electrode (27); producing a protective dielectric layer (28) conformally on the localized stack, the bottom electrode (27), and the planar support surface; embedding the localized stack including the protective layer (28) in a dielectric embedding material (35) and planarizing said embedding material to the upper level of the protective layer (28) lying on top of the localized stack (20); forming electrical connections to the bottom and top electrodes (27,18) of the device.

## Description

### Field of the Invention

The present invention is related to the fabrication of Josephson junction devices applicable in a superconducting digital logic circuit.

### State of the art.

Superconducting digital logic (SDL) is one of the main technologies of interest for overcoming inherent limitations in terms of energy efficiency of CMOS based integrated circuits. An SDL circuit comprises superconducting wires and Josephson junctions. Josephson junctions are known in various forms, but in SDL circuits, the most common implementation takes the form of a device comprising a dielectric material sandwiched between two superconducting electrodes. In an SDL circuit, the Josephson junction device (hereafter abbreviated to `JJ device') enables changing the magnetic flux in a superconducting loop by an integer number of a single magnetic flux quantum (SFQ).

The material of choice for the electrodes of Josephson junction devices applied in SDL circuits has most often been niobium, with Al₂O₃ or amorphous silicon (hereafter abbreviated to 'α-Si') as the barrier layer. A Nb/α-Si/Nb stack is however not compatible with process steps which require temperatures higher than 150°C-200°C, such as many steps required in back end of line processing, because the Nb intermixes with silicon above this temperature, thereby reducing the thickness of the barrier. This makes it difficult also to scale down Josephson junctions of this type to the sub-micrometre sized dimensions required for high density SDL circuits. NbTiN has been studied as a material for the superconducting electrodes of the Josephson junction as well as for conductors of superconducting circuitry applied for interconnecting JJ devices.

Process conditions for reliably producing JJ devices at submicron dimensions and high device densities in any material are under development and various problems are being encountered. One issue is the vulnerability of the sidewalls of the electrode stack of the device. These sidewalls are created by lithography and etching, but the exposed sidewalls are often incompatible with subsequent process steps.

### Summary of the invention

The invention is related to a method as disclosed in the appended claims. According to the invention, a stack of layers is formed on a planar support surface, the stack comprising at least a bottom superconducting layer, a barrier layer and a top superconducting layer. The top superconducting layer and the barrier layer are patterned relative to the bottom superconducting layer to form the top electrode and the barrier of the device. Then the bottom superconducting layer is patterned to form the bottom electrode and thereafter a conformal dielectric encapsulation layer is formed. The term 'conformal' within the present context is defined as a layer that follows the topography of the surface onto which it is deposited. Implicitly, this means that the layer's thickness is suitable for this purpose, i.e. the layer is thin compared to the dimensions of the features defining said topology.

The encapsulation enables protecting the sidewalls of the eventual Josephson junction device such as during the formation of electrical contacts to the device electrodes. According to a preferred embodiment, a double encapsulation is applied : a first encapsulation layer is applied on the barrier and top electrode before patterning the bottom superconducting layer and a second encapsulation layer is applied after patterning said bottom superconducting layer.

The method enables to maintain control of device dimensions for devices having in-plane dimensions of less than 500 nm, produced across a large substrate, such as a Si process wafer, thereby enabling also to produce large numbers of devices a high device density. According to preferred embodiments, the stack further comprises a dielectric layer on the top superconducting layer, included to act as etch stop layer and CMP stopping layer at respective stages of the process, and a hardmask layer included for patterning the top superconducting layer and the barrier layer.

The invention is in particular related to a method for producing a Josephson junction device comprising a bottom superconducting electrode, a top superconducting electrode and a barrier layer sandwiched between said bottom and top electrodes, the method comprising the steps of :
- producing on a planar support surface, a stack comprising :
   ∘ a bottom superconducting layer,
   ∘ a barrier layer directly on said bottom superconducting layer,
   ∘ a top superconducting layer directly on the barrier layer,
- patterning the barrier layer and the top superconducting layer, so as to form a localized stack comprising :
   ∘ the barrier of the device,
   ∘ the top electrode of the device,
- patterning the bottom superconducting layer so as to form on the planar surface of the support substrate :
   ∘ the bottom electrode of the device,
   ∘ the localized stack directly on the bottom electrode,
- producing a protective dielectric layer conformally on the localized stack, the bottom electrode, and the planar support surface,
- embedding the localized stack including the protective layer in a dielectric embedding material and planarizing said embedding material to the upper level of the protective layer lying on top of the localized stack,
- forming electrical connections to the bottom and top electrodes of the device.

According to an embodiment, said protective layer is a second protective layer, and :
- before patterning the bottom superconducting layer, a first protective layer is formed conformally on the localized stack and on the bottom superconducting layer, so that the first protective layer conformally covers the localized stack and the upper surface of the bottom electrode,
- after patterning the bottom superconducting layer, the second protective dielectric layer is formed conformally on the first protective layer, on the bottom electrode, and on the planar support surface,
- the localized stack and the bottom electrode, including the first and second protective layers are embedded in said dielectric embedding material,
- said dielectric embedding material is planarized to the upper level of the combined first and second protective layers lying on top of the localized stack.

According to an embodiment, the stack further comprises a dielectric layer directly on the top superconducting layer, wherein said dielectric layer is patterned together with the barrier layer and the top superconducting layer, so that the localized stack comprises a dielectric portion directly on the top electrode.

According to an embodiment, the stack further comprises a hardmask layer directly on the dielectric layer and patterning the barrier layer and the top superconducting layer comprises :
- producing a lithographic stack including at the top of said lithographic stack a resist layer, on the hardmask layer,
- patterning the resist layer to form a resist mask,
- transferring the resist mask into the rest of the lithographic stack and the hardmask layer by etching, stopping on the dielectric layer,
- stripping the resist mask and the rest of the patterned lithographic stack, leaving only a patterned hardmask,
- transferring the patterned hardmask to the top superconducting layer and the barrier layer by etching, thereby forming the localized stack comprising the barrier of the device, the top electrode of the device, the dielectric portion and the hardmask.

According to an embodiment, the thickness of the hardmask layer is chosen so that the patterned hardmask is consumed by the etch process applied for transferring said patterned hardmask to the top superconducting layer and the barrier layer.

According to an embodiment, a connection is produced to the upper electrode of the device by removing the combined protective layers from the upper surface of the localized stack, and by producing a via opening through the dielectric portion and filling said opening with a superconducting material.

According to an embodiment, a planarization step that stops on the upper surface of the dielectric portion, prior to producing said via opening.

According to an embodiment, the embedding material, the protective layers lying on the upper surface of the localized stack and any additional layers of the localized stack are etched back simultaneously until the dielectric portion is exposed.

According to an embodiment, the embedding material, the protective layers lying on the upper surface of the localized stack, any additional layers of the localized stack and the protective portion are etched back simultaneously until the top electrode of the device is exposed, wherein a connection is produced to the top electrode by producing a conductive line in direct contact with said top electrode.

According to an embodiment, the method further comprises the step of depositing an electrically conductive layer conformally on the localized stack and on the bottom superconducting layer, prior to depositing said first protective layer, and wherein said first protective layer is deposited directly on the electrically conductive layer.

According to an embodiment, patterning the barrier layer and the top superconducting layer is done by an etch process that is stopped by end point detection based on detection of the complete removal of material of the barrier layer from the surface of the bottom superconducting layer.

According to an embodiment, the bottom superconducting layer comprises a bottom portion, an etch stop layer and a top portion, and patterning the barrier layer and the top superconducting layer is done by an etch process that stops on the etch stop layer.

According to an embodiment, the bottom electrode is shaped as a conductive line.

According to an embodiment, the bottom and top superconducting layers are formed of NbTiN and the barrier layer comprises amorphous silicon.

The invention is equally related to a superconducting digital circuit comprising one or more Josephson junction devices produced by the method according to any one of the preceding claims.

### Brief description of the figures

Figures 1 to 9 illustrate key method steps of the method according to an embodiment of the invention.
Figure 10 illustrates an example of a layout of Josephson junction devices obtainable with the method of the invention.
Figures 11 to 16 illustrate one process flow for producing a via connection and conductive line connected to a JJ device produced in accordance with the invention.
Figures 17 to 21 illustrate a number of alternative process flows for producing a conductive line connected to a JJ device formed in accordance with the invention.
Figures 22 to 26 illustrate an embodiment including the production of a shunt connection between the electrodes of the JJ device.
Figures 27 to 29 illustrate an embodiment wherein an etch stop layer is incorporated in the layer that will eventually be patterned to form the bottom electrode of the JJ device.
Figures 30 to 32 illustrate an embodiment wherein a single encapsulation is applied instead of a double encapsulation.

### Detailed description of the invention

A number of embodiments of the method of the invention are described hereafter in some detail. Dimensions and materials are cited purely by way of example and are not limiting the scope of the invention, said scope being defined only by the appended independent claims.

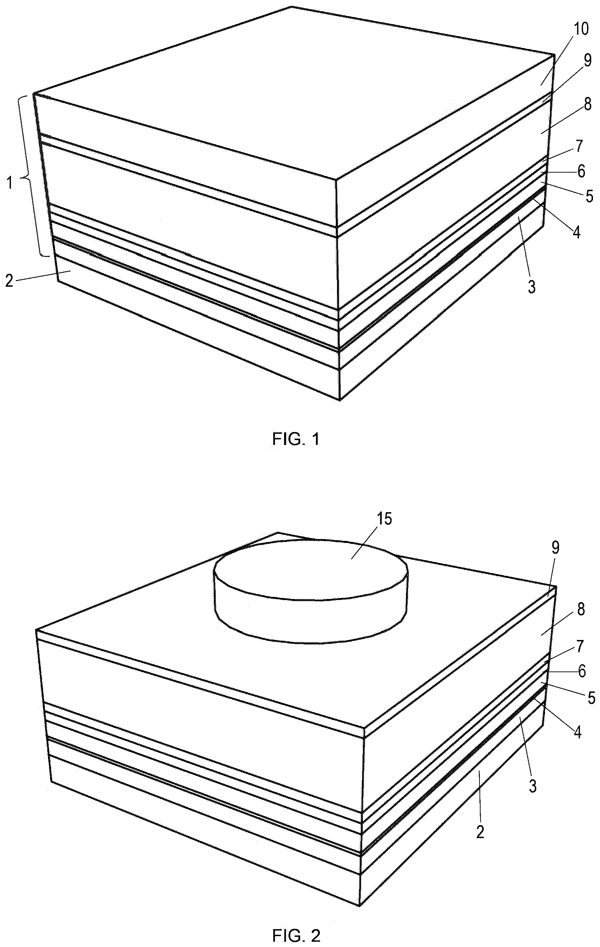

A first embodiment is described with reference to Figures 1 to 16. Figure 1 shows a small portion of a stack 1 of layers formed on the planar upper surface of a support layer 2. The in-plane dimensions of the illustrated stack portion are very small, in the order of a few hundred nanometres. The layers of the stack are however produced on the entire surface of the support layer 2 which may for example be formed on a standard silicon process wafer having a diameter of 200 mm or 300 mm. Layer 2 may be a dielectric layer 2 formed directly on the wafer surface or it may be a layer of a BEOL type layer stack formed on the process wafer, said layer stack including multiple interconnect levels comprising conductors formed of superconducting material embedded in consecutive layers of dielectric material. In the latter case, layer 2 is formed during the building-up process of the BEOL layer stack and the method steps of the invention are part of said process.

Method steps are described hereafter for producing a Josephson junction device in the illustrated stack portion. In practice, the method steps are applied simultaneously across the surface of the support layer 2, to thereby produce multiple JJ devices which are interconnected according to a given layout in a number of designated die areas, with a high number of devices arranged in each die area.

In the embodiment shown, the stack 1 is formed on a silicon oxide layer 2 The silicon oxide layer's compositional formula is SiO₂, with possible small deviations from the pure stoichiometric composition defined by the formula. Silicon oxide defined in this way will hereafter be referred to as 'SiOx'. However, the support layer 2 may be formed of any other suitable dielectric material.

On the SiOx layer 2, a layer 3 of NbTiN is formed of about 50 nm thick, followed by an amorphous silicon layer 4 (hereafter abbreviated as 'α-Si layer') of about 5-10 nm thick, and again a NbTiN layer 5 of about 50 nm thick. These NbTiN layers 3 and 5 with the α-Si layer 4 sandwiched therebetween are respectively the electrode layers and the barrier layer from which the electrodes and the barrier of the JJ device will be processed.

Instead of an α-Si layer, the barrier layer 4 could be a stack of a α-Si layer and on top of said α-Si layer a thin intermixed Si/Ti layer. This intermixed layer is obtainable by depositing Ti directly on a 10 nm α-Si layer under increased temperature, as described in EP application nr. EP 23213425.4 by the same applicant. The invention is however not limited by any particular type, structure or material of the barrier layer 4 nor of the superconducting electrode layers 3 and 5.

A silicon nitride layer 6 of about 30 nm thick is formed directly on the top electrode layer 5, followed by a SiOx (as defined above) layer 7 of about the same thickness as the SiN layer 6. As will be described further in this text, the SiN layer 6 will play the part of etch stop layer and CMP stopping layer later in the process, while the SiOx layer 7 will play the part of a hardmask layer. The composition of the silicon nitride layer is Si₃N₄ with possibly small deviations from the exact stoichiometric coefficients 3 and 4. Silicon nitride defined in this way will hereafter be referred to as 'SiN'. Methods for producing the layers 2 to 7 of the stack as described above are well known to the skilled person and need not be described here in detail.

A lithographic stack 8,9,10 is formed on the SiOx layer 7, the stack comprising : an amorphous carbon layer 8, an SiOC (silicon oxycarbide) layer 9 and a resist layer 10. This is a well-known type of litho stack, and thicknesses of its constituting layers may be in accordance with known practice. Other litho-stacks could be applied and the materials of layers 8,9,10 can be chosen in accordance with known material combinations.

The resist layer 10 is patterned by exposure to light through a patterned mask and after development and stripping of the non-patterned resist, a resist mask 15 remains, as illustrated in Figure 2. The mask has a circular cross-section with a diameter of about 300 nm.

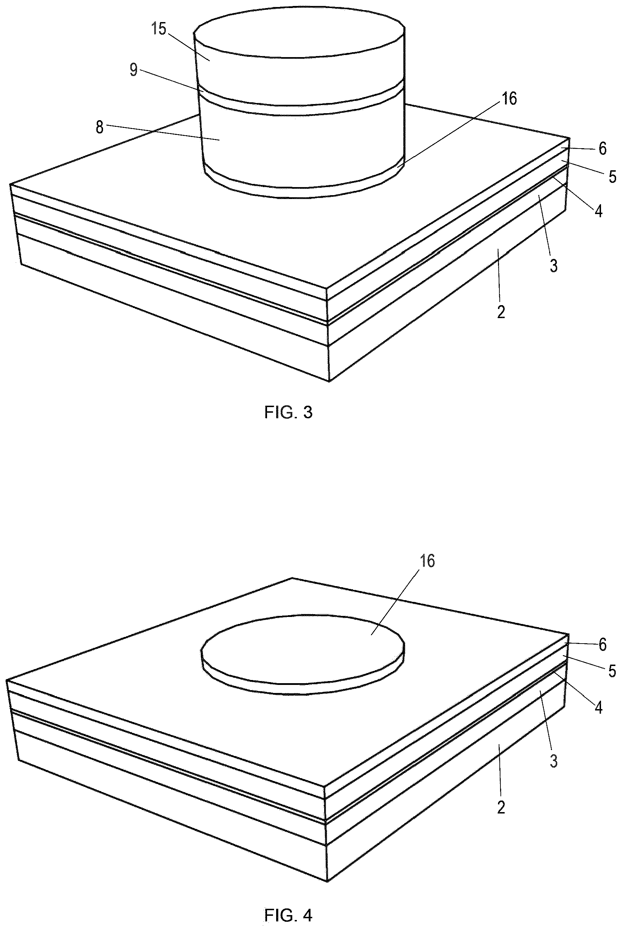

With reference to Figure 3, the resist mask 15 is then transferred by etching, to the underlying layers, the SiOC layer 9, the amorphous carbon layer 8, and the SiOx layer 7, by an etch process that is selective with respect to SiN, so that the etch stops on the SiN layer 6. This represents the etch stop function of this SiN layer 6. The patterned SiOx layer 7 now becomes a patterned hardmask 16 having the same diameter as the resist mask 15.

The litho stack (resist 15, SiOC 9 and amorphous carbon 8) is then stripped relative to the SiN layer 6 and the SiOx hardmask 16, resulting in the image shown in Figure 4 : only the SiOx hardmask 16 remains on top of the SiN layer 6.

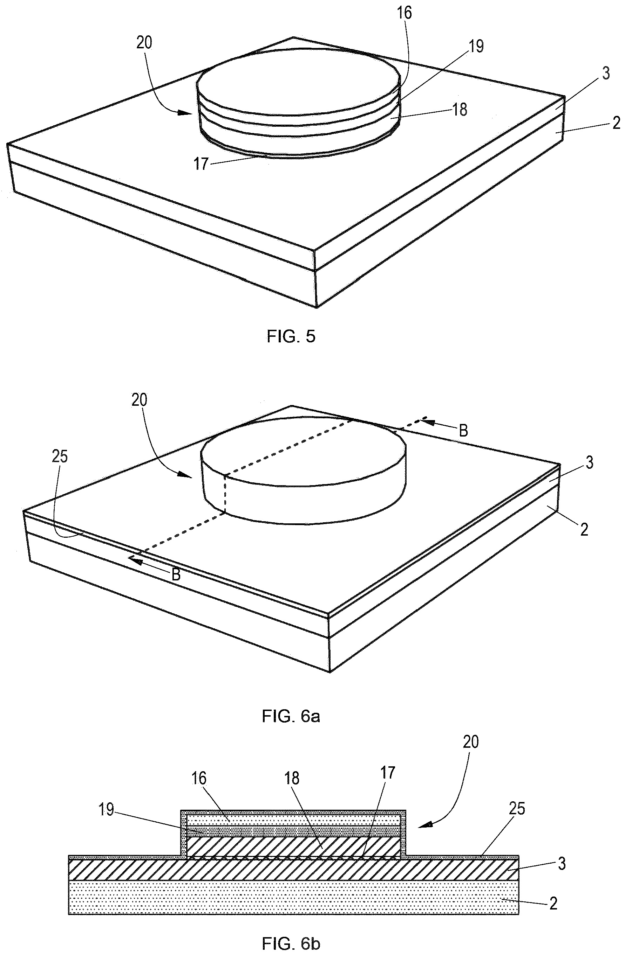

By a plasma etch process illustrated in Figure 5, the SiOx hardmask 16 is transferred to the underlying SiN layer 6, the top electrode layer 5 and the barrier layer 4, i.e. the material of these layers is removed anisotropically with respect to the SiOx hardmask 16, leaving a cylindrical localized stack 20 as illustrated in Figure 5 and comprising the barrier 17 of the JJ device, the top electrode 18 of the JJ device, a patterned portion 19 of SiN, and the SiOx hardmask 16.

When NbTiN is used as the superconducting material, stripping the litho stack typically requires O₂ plasma etching which can be damaging to the sidewalls of the layers of the eventual JJ device. The approach described here prevents damage to the sidewalls because the litho mask layers 8,9,15 are stripped prior to etching the device layers. Said latter etch process is then a non-oxygen based plasma etch process, for example chloride or fluoride based, that is not detrimental to the sidewall integrity. The invention however also includes embodiments wherein the litho stack is stripped after etching the top electrode layer 5 and the barrier layer 4. This may for example be applicable when a superconducting material is used that is resistant to O₂ plasma. The invention is in any case not limited by any particular method for etching the top electrode and barrier layer, either in terms of the applied etch chemistries and the applied materials.

According to the embodiment illustrated in Figure 5, the plasma etch for transferring the SiOx hardmask 16 is stopped by end point detection relative to the barrier layer material, i.e. the etching is stopped when no more species of the barrier layer 4 are detected in the etch chamber. According to another embodiment, this etch process is stopped by an etch stop layer, but this embodiment will be described separately later in this description.

Although this is not shown as such in the drawing, the thickness of the SiOx hardmask 16 may be somewhat reduced by the plasma etch process for producing the localized stack 20, compared to the thickness of the original SiOx layer 7, due to the fact that the selectivity of this process relative to SiOx is never 100 %. According to another embodiment also described later in more detail, the original thickness of the SiOx layer 7 is tuned so that the hardmask 16 is fully consumed during the plasma etch process.

Reference is now made to Figure 6a and the cross-section view in Figure 6b : a layer 25 of SiN (as defined above) is deposited conformally on the cylindrical stack 20, i.e. including the patterned SiN portion 19 and the SiOx hardmask 16. A conformal deposition is a deposition that follows the topography of the surface onto which the layer is deposited : the SiN layer has a thickness that enables such a conformal deposition. In the illustrated embodiment, said thickness of the conformal SiN layer 25 may be in the order of 10 nm. This may be realized by physical vapour deposition applied in-situ, i.e. in the same chamber as the plasma etch process used for patterning the barrier and top electrode layers. The conformal SiN layer 25 is a protective dielectric encapsulation layer that protects the sidewalls of the barrier 17 and the top electrode 18 during subsequent processing steps. As stated, all references to applied materials is merely exemplary. Hence, the use of SiN for the conformal layer 25 is not limiting the scope of the invention. Alternative applicable materials for layer 25 (and for layer 28 described later) include, among others, SiO₂, Al₂O₃, SiC.

The in-situ deposition referred to above is advantageous because it ensures that no native oxide growth occurs on the localized stack 20 prior to the deposition of the conformal layer 25. Nevertheless, it is also possible to deposit the conformal layer 'ex-situ', i.e. after exposing the localized stack 20 to an oxygen-containing atmosphere. In that case however, it may be required to precede the deposition of the conformal layer 25 by a precleaning step using a wet cleaning chemistry for removing the native oxide, or by an ion milling step. Pre-cleaning or ion milling after ex-situ deposition would not be required if the material used for layer 25 does not oxidize in air.

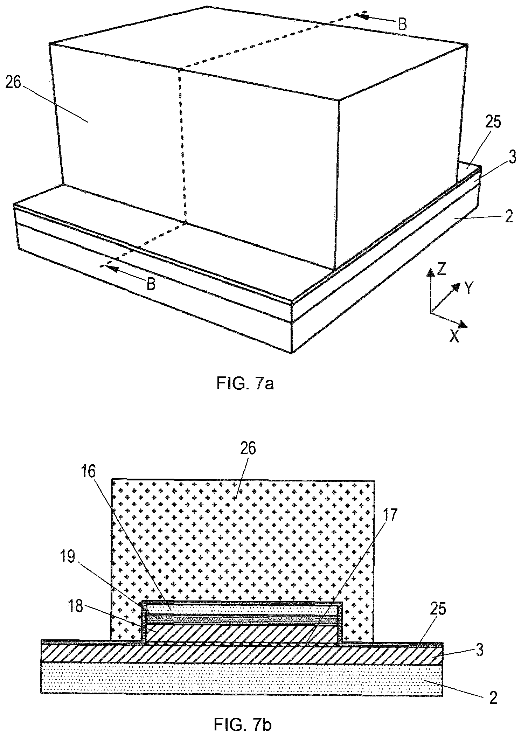

With reference to Figures 7a and 7b, a further hardmask is produced in the form of a line-shaped mask 26 extending in the X-direction of the XYZ orthogonal axis system illustrated in Figure 7a, and fully covering the cylindrical stack 20. The hardmask 26 may be formed in a manner known as such and the exact structure of the mask is not shown in detail (it may for example be a stack of amorphous carbon and SiOC, patterned by etching following the patterning of a resist layer, etc.). The width of the line-shaped hardmask 26 is in the order of 400 nm in the illustrated embodiment.

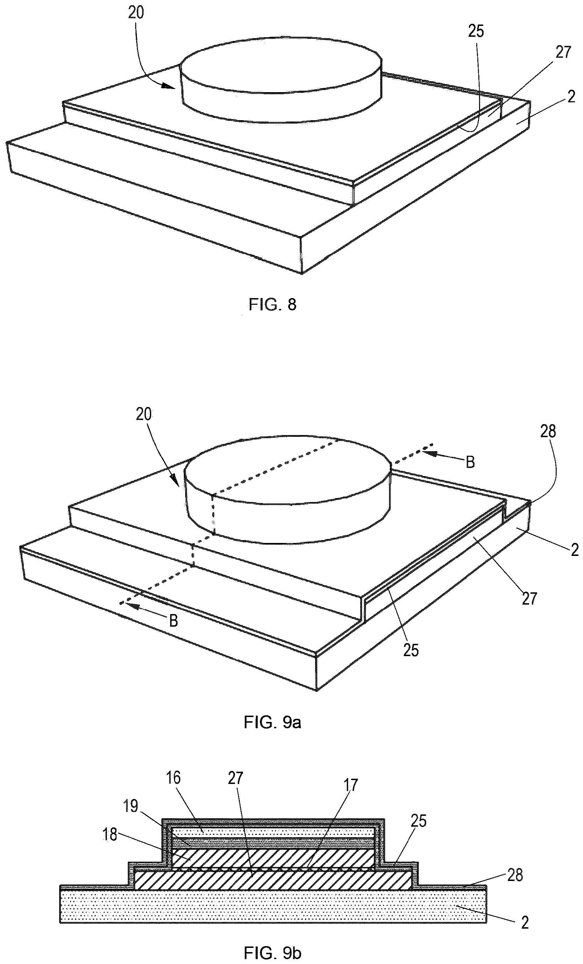

As shown in Figure 8, the line-shaped hardmask 26 is transferred to the underlying conformal protection layer 25 and the bottom electrode layer 3 by a further anisotropic plasma etch, stopping on the SiOx isolation layer 2, so that a line-shaped bottom electrode 27 is formed on said isolation layer 2, said bottom electrode 27 extending in the X-direction. The image shown in Figure 8 represents the structure after stripping of the hardmask 26.

A second SiN conformal layer 28 is then deposited by PVD, as illustrated in Figures 9a and 9b. The second conformal layer 28 thereby encapsulates the surface and sidewalls of the bottom electrode 27 whilst realizing a double encapsulation of the barrier 17 and the top electrode 18 of the JJ device. This double encapsulation by conformal dielectric layers of a dielectric material, in this case SiN, further protects the sidewalls of the device layers and enables minimizing electrical losses of the eventual JJ device. In the section view in Figure 9b, the conformal SiN layers 25 and 28 are represented as separate layers, but these layers could merge and form a uniform SiN layer.

The second conformal layer 28 can be deposited in-situ or ex-situ, as described in relation to the first conformal layer 25.

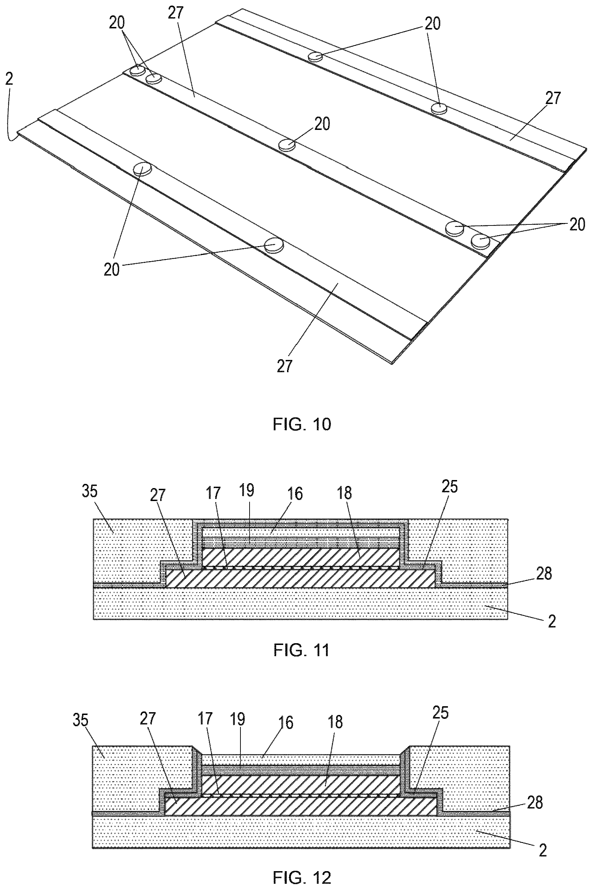

The line-shaped bottom electrode 27 will serve as the bottom electrode for a plurality of JJ devices, as illustrated in the example of a possible layout in Figure 10, wherein multiple barrier/top electrode stacks 20 (including the double encapsulation) have been processed in the manner described above, on a number of parallel line-shaped bottom electrodes 27. Interconnecting the JJ devices is achieved by a number of subsequent steps, described hereafter, again with reference to a single device, but in the knowledge that in practice, these steps are performed simultaneously for a large number of devices processed on a given wafer. Processing steps are now described with reference only to section views of the device.

With reference to Figure 11, the stack of the patterned bottom electrode 27, the barrier 17, the top electrode 18, the SiN portion 19 and the SiOx hardmask 16 is embedded in a dielectric layer 35, which may be a silicon oxide layer or a low-K dielectric layer, or any other layer suitable as an interlayer dielectric material (ILD) in a back end of line interconnect structure as known from standard Si-based CMOS process flows. Figure 11 demonstrates that the ILD layer 35 is planarized by standard planarization techniques, possibly including CMP (chemical mechanical polishing), stopping on the upper surface of the double SiN encapsulation layer 25+28.

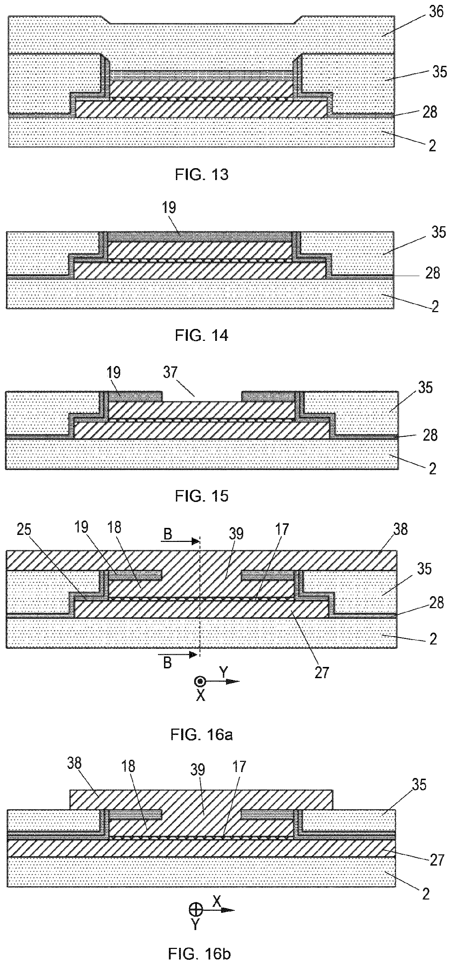

The SiN of layers 25 and 28 is then etched back relative to the ILD material 35, as shown in Figure 12, and the obtained recess is filled with a layer 36 of SiOx, deposited also on the planarized ILD surface, as illustrated in Figure 13, followed by another planarization step preferably ending with a CMP step, stopping on the upper surface of the cylindrical SiN portion 19 originating from the layer 6 of the original stack, as illustrated in Figure 14. This illustrates the CMP stopping function of the original SiN layer 6.

This results in a planarized surface enabling subsequent processing steps for connecting the top electrode 18 of the JJ device to an interconnect line running in the Y-direction. As illustrated in Figure 15, a via opening 37 is formed through the SiN portion 19 by lithography and etching, the via opening 37 lying within the footprint of the top electrode 18. Preferably the via opening is concentrically arranged relative to said top electrode, but a certain misalignment is allowable as long as the via opening lies within the top electrode's surface area. With reference to Figure 16a, the opening 37 is filled with NbTiN that is deposited in said opening and in a layer on top of the planarized surface. As illustrated in the additional section view in Figure 16b, the NbTiN layer is then patterned to form a conductive line 38 running in the Y-direction, and connected to the JJ device though a via connection 39 (the filled via opening 37). Thereafter, the line 38 will be embedded in ILD material and additional interconnect levels may be formed in accordance with known methods.

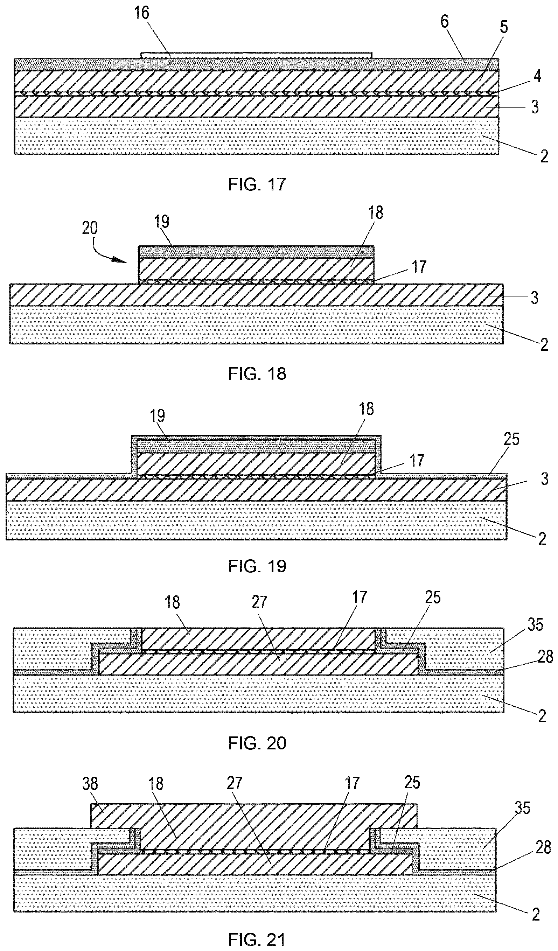

A number of alternative process flows are described hereafter. As stated, the thickness of the SiOx layer 7 can be tuned so that this layer is fully consumed during the plasma etch process applied for forming the cylindrical stack 20. Figures 17 and 18 illustrate this embodiment respectively before and after the plasma etch. This is followed by the deposition of the conformal SiN layer 25 directly on the sidewalls of the stack 20 and on the SiN portion 19 , as shown in Figure 19. After this, the process flow is the same as described above.

According to another alternative (not illustrated in the drawings), starting from the process stage illustrated in Figure 11, i.e. after ILD deposition and planarization, the material of the ILD layer 35, the SiN layers 25 and 28 and the SiOx hardmask 16 are etched back progressively from the planarized surface by an etch process that is not selective to any one of these materials, i.e. all these materials are etched essentially at the same rate. This etch process is stopped when the SiOx hardmask 16 is removed, resulting in a situation similar to the one shown in Figure 14, but not obtained through planarization, but only by etching. Thereafter, the formation and filling of the via opening 37 and the formation of the conductive line 38 may be done in the same way as described above.

According to another alternative process flow, the progressive etch process described in the previous paragraph continues until the cylindrical SiN portion 19 is removed, resulting in the image shown in Figure 20, i.e. the top electrode 18 is now exposed at the end of the etch process. Following this, and as illustrated in Figure 21, the conductive line 38 running in the Y-direction can now be formed in direct contact with the top electrode 18, i.e. no formation and filling of the via opening is required.

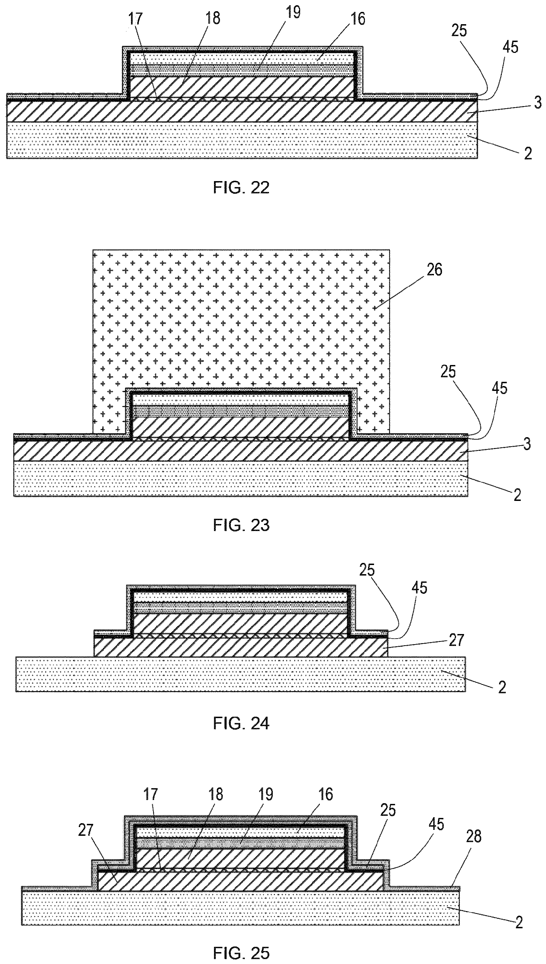

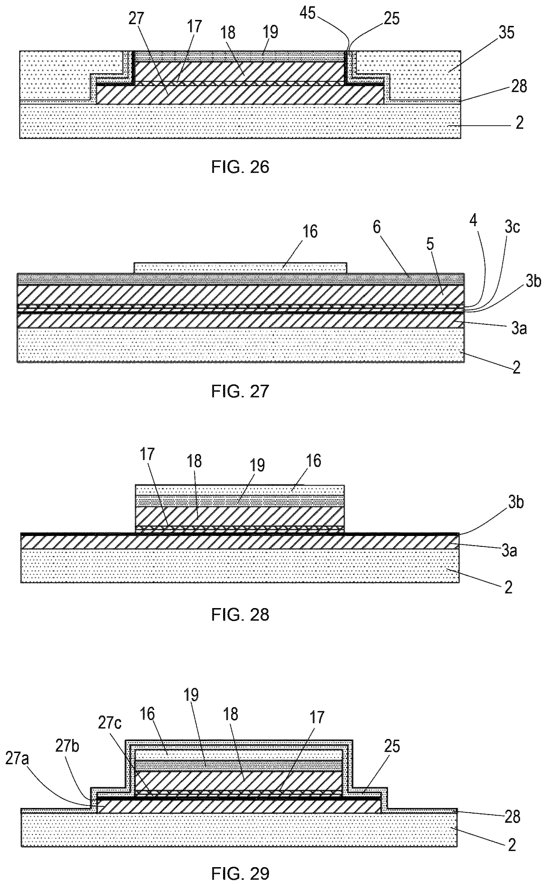

According to an embodiment that can be applied in combination with any of the process flows illustrated in Figures 11 to 21, an additional electrically conductive conformal layer is deposited on the patterned barrier 17 and top electrode 18 of the JJ device, prior to the deposition of the conformal dielectric (e.g. SiN) layer 25. This embodiment is illustrated in Figures 22 to 26. The electrically conductive layer 45 may for example be a TiN layer of about 10 nm thick. Generally, the material of layer 45 is preferably a material exhibiting a small mean free path and having a resistivity higher than 1 mΩ-cm. Possibly, carbon and oxygen dopants can be implanted in this layer 45 to increase resistivity and reduce mean free path. In the eventual JJ device, the layer 45 will form a shunt connection between the top and bottom electrodes, which may be beneficial for reducing RC time constant of the Josephson junction device. After the planarization resulting in the image shown in Figure 26, process steps as described above can be applied for connecting the JJ device to a conductive line running in the Y-direction.

A further alternative embodiment is illustrated in Figures 27 to 29. The layer from which the bottom electrode will eventually be formed is now a stack of a bottom NbTiN layer 3a of about 30 nm thick, an etch stop layer 3b of about 10 nm thick and a further NbTiN layer 3c of about 10 nm thick. The material of the etch stop layer 3b may for example be aluminium The etch stop function of the etch stop layer 3b is related to the plasma etch process for patterning the top electrode 18 and the barrier layer 17, as illustrated in Figure 28 : the etch process is not stopped by end point detection, but continues until the etch stop layer 3b is reached. Following this, the method continues as described with reference to any of the previously described embodiments, including the deposition of the first conformal SiN layer 25, patterning of the bottom electrode and deposition of the second conformal SiN layer 28, as illustrated in Figure 29. The bottom electrode now comprises a first NbTiN portion 27a, a second portion 27b formed of the material of the etch stop layer, and a third portion 27c again formed of NbTiN.

The invention is not limited to the specific structure of the Josephson junction device as illustrated in the drawings, i.e. comprising a line-shaped bottom electrode and cylinder-shaped barrier 17 and top electrode. Other electrode shapes and dimensions are possible.

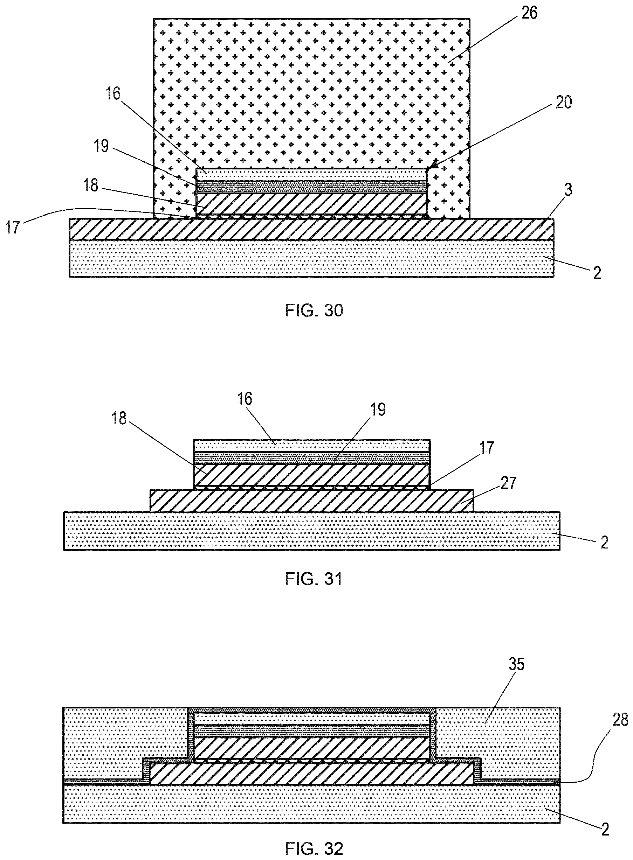

Although it is advantageous to provide the double encapsulation described hereabove, the invention scope includes also an embodiment wherein only a single encapsulation layer is applied. This embodiment is illustrated in Figures 30 to 32. As seen in Figures 30 and 31, the bottom superconducting layer 3 is patterned to form the bottom electrode 27 directly after forming the localized stack 20, i.e. without first depositing the conformal layer 25. Thereafter, as illustrated in Figure 32, a single dielectric encapsulation layer 28 is formed, followed by the deposition of the ILD layer 35 and the planarization thereof to the level of the single encapsulation layer 28.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A method for producing a Josephson junction device comprising a bottom superconducting electrode (27), a top superconducting electrode (18) and a barrier layer (17) sandwiched between said bottom and top electrodes, the method comprising the steps of :
- producing on a planar support surface, a stack (1) comprising :
∘ a bottom superconducting layer (3),
∘ a barrier layer (4) directly on said bottom superconducting layer (3),
∘ a top superconducting layer (5) directly on the barrier layer (4),
- patterning the barrier layer (4) and the top superconducting layer (5), so as to form a localized stack (20) comprising :
∘ the barrier (17) of the device,
∘ the top electrode (18) of the device,
- patterning the bottom superconducting layer (3) so as to form on the planar surface of the support substrate (2) :
∘ the bottom electrode (27) of the device,
∘ the localized stack (20) directly on the bottom electrode (27),
- producing a protective dielectric layer (28) conformally on the localized stack (20), the bottom electrode (27), and the planar support surface,
- embedding the localized stack including the protective layer (28) in a dielectric embedding material (35) and planarizing said embedding material to the upper level of the protective layer (28) lying on top of the localized stack (20),
- forming electrical connections to the bottom and top electrodes (27,18) of the device.

2. The method according to claim 1, wherein said protective layer (28) is a second protective layer, and wherein :
- before patterning the bottom superconducting layer (3), a first protective layer (25) is formed conformally on the localized stack (20) and on the bottom superconducting layer (3), so that the first protective layer (25) conformally covers the localized stack (20) and the upper surface of the bottom electrode (27),
- after patterning the bottom superconducting layer (3), the second protective dielectric layer (28) is formed conformally on the first protective layer (25), on the bottom electrode (27), and on the planar support surface,
- the localized stack and the bottom electrode (27), including the first and second protective layers (25,28) are embedded in said dielectric embedding material (35),
- said dielectric embedding material (35) is planarized to the upper level of the combined first and second protective layers (25,28) lying on top of the localized stack (20).

3. The method according to claim 1 or 2, wherein the stack (1) further comprises a dielectric layer (6) directly on the top superconducting layer (5), and wherein said dielectric layer (6) is patterned together with the barrier layer (4) and the top superconducting layer (5), so that the localized stack (20) comprises a dielectric portion (19) directly on the top electrode (18).

4. The method according to claim 3, wherein the stack (1) further comprises a hardmask layer (7) directly on the dielectric layer (6) and wherein patterning the barrier layer (4) and the top superconducting layer (5) comprises :
- producing a lithographic stack (8,9,10) including at the top of said lithographic stack a resist layer (10), on the hardmask layer (7),
- patterning the resist layer (10) to form a resist mask (15),
- transferring the resist mask (15) into the rest of the lithographic stack and the hardmask layer (7) by etching, stopping on the dielectric layer (6),
- stripping the resist mask (15) and the rest of the patterned lithographic stack (8,9), leaving only a patterned hardmask (16),
- transferring the patterned hardmask (16) to the top superconducting layer (5) and the barrier layer (4) by etching, thereby forming the localized stack (20) comprising the barrier (17) of the device, the top electrode (18) of the device, the dielectric portion (19) and the hardmask (16).

5. The method according to claim 4, wherein the thickness of the hardmask layer (7) is chosen so that the patterned hardmask (16) is consumed by the etch process applied for transferring said patterned hardmask (16) to the top superconducting layer (5) and the barrier layer (4).

6. The method according to any one of claims 3 to 5, wherein a connection is produced to the upper electrode (18) of the device by removing the combined protective layers (25,28) from the upper surface of the localized stack (20), and by producing a via opening (37) through the dielectric portion (19) and filling said opening with a superconducting material.

7. The method according to claim 6, comprising a planarization step that stops on the upper surface of the dielectric portion (19), prior to producing said via opening (37).

8. The method according to claim 6, wherein the embedding material (35), the protective layers (25,28) lying on the upper surface of the localized stack (20) and any additional layers of the localized stack are etched back simultaneously until the dielectric portion (19) is exposed.

9. The method according to any one of claims 3 to 5, wherein the embedding material (35), the protective layers (25,28) lying on the upper surface of the localized stack (20), any additional layers of the localized stack and the protective portion (19) are etched back simultaneously until the top electrode (18) of the device is exposed, and wherein a connection is produced to the top electrode (18) by producing a conductive line (38) in direct contact with said top electrode (18).

10. The method according to any one of the preceding claims, further comprising the step of depositing an electrically conductive layer (45) conformally on the localized stack (20) and on the bottom superconducting layer (3), prior to depositing said first protective layer (25), and wherein said first protective layer is deposited directly on the electrically conductive layer (45).

11. The method according to any one of the preceding claims, wherein patterning the barrier layer (4) and the top superconducting layer (5) is done by an etch process that is stopped by end point detection based on detection of the complete removal of material of the barrier layer (4) from the surface of the bottom superconducting layer (3).

12. The method according to any one of claims 1 to 10, wherein the bottom superconducting layer (3) comprises a bottom portion (3a), an etch stop layer (3b) and a top portion (3c), and wherein patterning the barrier layer (4) and the top superconducting layer (5) is done by an etch process that stops on the etch stop layer (3b).

13. The method according to any one of the preceding claims, wherein the bottom electrode (27) is shaped as a conductive line.

14. The method according to any one of the preceding claims, wherein the bottom and top superconducting layers (3,5) are formed of NbTiN and wherein the barrier layer (4) comprises amorphous silicon.

15. A superconducting digital circuit comprising one or more Josephson junction devices produced by the method according to any one of the preceding claims.
